Europäisches Patentamt

European Patent Office

Office européen des brevets

(19)

(11) Numéro de publication : **0 382 610 B1**

(12) **FASCICULE DE BREVET EUROPEEN**

(45) Date de publication du fascicule du brevet :
15.12.93 Bulletin 93/50

(51) Int. Cl.$^5$ : **G11C 27/02**

(21) Numéro de dépôt : **90400286.2**

(22) Date de dépôt : **01.02.90**

(54) **Echantillonneur-bloqueur hyperfréquence à transistor.**

(30) Priorité : **07.02.89 FR 8901532**

(43) Date de publication de la demande :
**16.08.90 Bulletin 90/33**

(45) Mention de la délivrance du brevet :
**15.12.93 Bulletin 93/50**

(84) Etats contractants désignés :
**DE GB NL**

(56) Documents cités :
**US-A- 4 068 135
US-A- 4 140 914
IBM TECHNICAL DISCLOSURE BULLETIN,
vol. 29, no. 5, octobre 1986, pages 1968-1969,
New York, US; "Subpicosecond optical sampling gate"
ELEKTRONIK, vol. 34, no. 19, septembre 1985,
page 106, Munich, DE; M. HANDWERKER:
"Analogspeicher in neuem Gewand"**

(56) Documents cités :
**PATENT ABSTRACTS OF JAPAN, vol. 9, no. 75
(E-306), 4 avril 1985, page 96 E 306; & JP-A-59
210 701 (NIPPON DENSHIN DENWA KOSHA)
29-11-1984
PATENT ABSTRACTS OF JAPAN, vol. 4, no.
185 (E-38), 19 décembre 1980, page 81 E 38; &
JP-A-55 127 706 (NIPPON TELEGR. &
TELEPH.) 02-10-1980**

(73) Titulaire : **THOMSON COMPOSANTS
MICROONDES
51, Esplanade du Général de Gaulle
F-92800 Puteaux (FR)**

(72) Inventeur : **Guiberteau, Christian, Thomson
CSF
SCPI, Cédex 67
F-92045 Paris La Defense (FR)**
Inventeur : **Ruggeri, Stéphane, Thomson CSF
SCPI, Cédex 67
F-92045 Paris La Défense (FR)**
Inventeur : **Le Paih, Michèle, Thomson CSF
SCPI, Cédex 67
F-92045 Paris La Défense (FR)**

(74) Mandataire : **Taboureau, James et al
THOMSON-CSF, SCPI, B.P. 329, 50, rue
Jean-Pierre Timbaud
F-92402 Courbevoie Cédex (FR)**

EP 0 382 610 B1

**Description**

La présente invention concerne un échantillonneur-bloqueur dont l'interrupteur d'échantillonnage est un transistor à effet de champ. Il est caractérisé en ce que le transistor est à commande optique, soit au moyen d'un laser semiconducteur directement couplé à la région de grille du transistor, soit au moyen d'un laser et d'une fibre optique. La commande optique du transistor, qui est en matériaux III-V tels que GaAs ou InP, permet à l'échantillonneur-bloqueur de travailler à des fréquences de l'ordre de 1 GHz au moins.

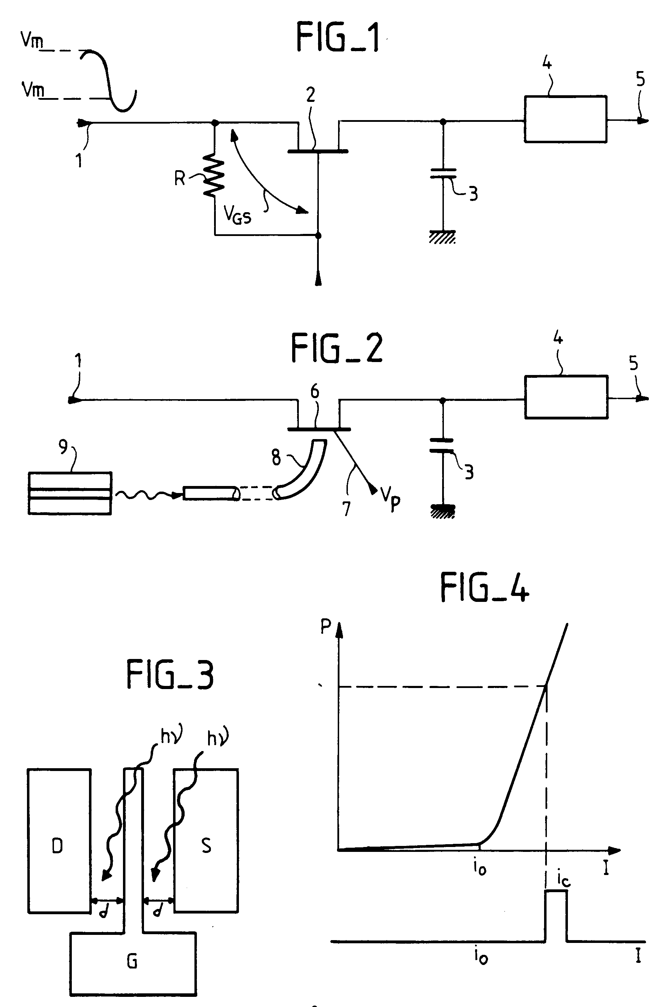

Les échantillonneurs-bloqueurs à transistor tel que celui représenté en figure 1 sont bien connus. Un signal analogique - symbolisé par une sinusoïde - est appliqué à l'entrée 1 de l'échantillonneur, sur la source d'un transistor 2 qui sert d'interrupteur. Ce transistor est fréquemment à effet de champ, et il peut être en silicium ou en matériaux III-V tel que GaAs, selon la fréquence de travail. Lorsque le transistor 2 est conducteur, le signal charge une capacité 3 de mémorisation. Un interface de sortie 4 délivre sur la sortie 5 des valeurs échantillonnées qui sont, selon la nature de l'interface, amplifiées, ou numérisées, ou mixées avec d'autres valeurs etc... .

Le transistor 2 est commandé sur sa grille par un train d'impulsions représentées par une tension $V_i$. La grille et la source sont réunies par une charge R pour que, en période de suivi, les potentiels de grille et de source soient égaux. Dans ce système classique, les paires électrons-trous sont créees par voie électrique.

En fait, ce système qui convient parfaitement aux fréquences relativement basses - en mégahertz- souffre de défauts qui s'aggravent avec l'augmentation de fréquence. En effet, la tension $V_{GS}$ entre la grille et la source, qui commande l'ouverture et la fermeture du canal, est la somme de la tension du signal analogique et de la tension d'impulsion $V_i$. Selon que le signal analogique est échantillonné en un point où sa tension $V_M$ est proche du maximum, ou en un point où sa tension $V_m$ est proche du minimum, la tension $V_{GS}$ varie parce que $V_M + V_i = V_m + V_i$. Il en résulte une incertitude sur le moment de basculement du transistor 2, donc une incertitude sur le moment d'échantillonnage du signal analogique, d'où il découle que le transistor perd sa linéarité avec l'élévation de fréquence.

Par ailleurs, le développement des fibres optiques pour transmettre l'information est à l'origine de l'intérêt croissant de disposer de systèmes directement commandés par la lumière. En outre, la commande optique de dispositifs possède de nombreux avantages tels que l'absence de couplage électrique et l'isolation du circuit de commande, la faible amplitude du signal de commande optique- quelques microwatts- compatible avec les niveaux de sortie des lasers à semiconducteurs ou des diodes électroluminescentes et l'immunité au brouillage.

Or, il est connu que les matériaux du groupe III-V tels que GaAs, InP et leurs dérivés ternaires et quaternaires sont sensibles à un rayonnement lumineux de longueur d'onde appropriée, ce qui ouvre des perspectives à l'utilisation de systèmes dans lesquels des circuits intégrés traitent simultanément des signaux optiques et des signaux électroniques.

C'est donc un premier objet de l'invention de proposer un échantillonneur-bloqueur comportant un transistor en matériaux du groupe III-V commandé par une lumière de longueur d'onde appropriée. Sur la grille du transistor est appliquée une tension très voisine de la somme de sa tension de seuil et de $V_m$ : le basculement du transistor est commandé par un rayon lumineux issu d'un laser semiconducteur.

C'est un second objet de l'invention d'obtenir un échantillonneur-bloqueur ayant une grande linéarité de réponse, et une grande vitesse d'échantillonnage, parce qu'il n'y a plus d'incertitude sur le moment de basculement de l'interrupteur que constitue le transistor.

Un autre objet de l'invention est encore d'obtenir une excellente immunité aux rayonnements électromagnétiques et aux parasites électriques, puisque la commande de l'échantillonneur-bloqueur est optique.

Enfin, l'échantillonneur-bloqueur selon l'invention est intégrable sur la pastille d'un circuit intégré, et la puissance optique nécessaire pour l'actionner est inférieure à celle délivrée par un laser semiconducteur, et la puissance consommée par ce laser est inférieure à celle consommée par un montage électronique réalisant la même fonction.

De façon plus précise l'invention consiste en un échantillonneur-bloqueur hyperfréquence, comportant un interrupteur placé entre l'entrée d'un signal électrique et une capacité de mémorisation, cet échantillonneur-bloqueur étant caractérisé en ce que l'interrupteur est un transistor à effet de champ muni d'une commande optique sur sa région de canal.

L'invention sera mieux comprise par la description plus détaillée qui est donnée d'un exemple de réalisation, en s'appuyant sur les figures jointes en annexe, qui représentent :
- figure 1 : échantillonneur-bloqueur selon l'art connu, précédemment décrit,
- figure 2 : échantillonneur-bloqueur selon l'invention,
- figure 3 schéma en plan des métallisations d'un transistor interrupteur dans un échantillonneur- bloqueur selon l'invention,
- figure 4 : courbe de réponse d'un laser semiconducteur utilisé pour commander le transistor d'un échantillonneur-bloqueur selon l'invention.

Le schéma de principe d'un échantillonneur-bloqueur selon l'invention est donné en figure 2. Comme dans l'art connu, un signal analogique présent sur l'entrée 1 est mémorisé dans une capacité 3 lorsque l'interrupteur 6 est conducteur pendant un temps très court. Un interface de sortie 4 traite les échantillons stockés dans la capacité 3 et les délivre sur la sortie 5.

L'originalité de cet échantillonneur-bloqueur est que l'interrupteur 6 est un transistor à commande optique. Ce transistor est réalisé en matériaux III-V, dont les plus utilisés sont GaAs, $Al_xGa_{1-x}As$ et InP. C'est donc un transistor à effet de champ, dont la structure interne n'a pas à être détaillée içi : ce peut être un MESFET, ou un transistor à hétérojonction tel qu'un TEGFET, et il peut être normalement bloqué, ou normalement passant, à condition d'être polarisé par une tension de grille suffisante pour pincer le canal. La caractéristique principale demandée à ce transistor est d'être sensible à la lumière, et d'avoir une fréquence de coupure élevée.

La distinction entre les différents types d'absorption dans le matériau semiconducteur est liée à l'énergie du faisceau lumineux incident par rapport à la largeur de la bande interdite du matériau.

Ainsi lorsque l'énergie du rayonnement incident est égale ou supérieure à la largeur de la bande interdite du matériau ($h\nu > Eg$), il y a absorption intrinsèque de la lumière. Des électrons sont transférés de la bande de conduction avec conservation du moment dans le cas de la transition directe interbandes. Le seuil d'absorption caractérise l'énergie du rayonnement incident pour lequel on a $h\nu = Eg$.

L'absorption intrinsèque se produit lorsque la longueur d'onde du rayonnement incident est telle que :

$$\lambda \ (nm) < \frac{K}{Eg \ (ev)}$$

K étant un coefficient.

GaAs est sensible à un rayonnement lumineux pour lequel $\lambda < 869$ nm (à 300° K) , et InP est sensible à un rayonnement $\lambda < 1500$ nm.

Le coefficient d'absorption caractérise la décroissance du flux incident de photons dans la direction de propagation du rayonnement lumineux à travers la couche active du transistor. Ce coefficient d'absorption est une fonction décroissante du dopage, et la couche active du transistor doit donc être fortement dopée, $\cong 10^{18}$ at. $cm^{-3}$.

Le transistor 6 est polarisé, par une tension continue $V_P$ appliquée sur sa grille par une métallisation 7, de telle façon qu'en l'absence d'éclairement il soit en un point proche mais inférieur à la somme de sa tension de seuil et de $V_m$ : le transistor est bloqué, et le signal d'entrée en 1 est isolé de la capacité de mémorisation 3.

Mais la région de canal du transistor 6 est en outre commandée par un faisceau optique, schématisé sur la figure 2 par une fibre optique 8 qui transmet le rayonnement produit par un laser semiconducteur 9.

Bien entendu, la commande optique peut être différente : par couplage direct d'un laser et d'un transistor, ou par une autre source de rayonnement qu'un laser semiconducteur : la fibre optique est seulement un moyen de couplage commode entre une source lumineuse et la région de canal d'un transistor.

Lorsque le laser 9 émet un rayonnement pulsé, à une longueur d'onde en relation avec le matériau du transistor, le signal optique crée dans la zone déplétée du transistor des paires électrons-trous qui assurent la circulation d'un courant entre source et drain du transistor, permettant la charge ou la décharge de la capacité 3 de mémorisation jusqu'à recopie parfaite de la tension d'entrée.

Pendant l'extinction du laser 9, le transistor 6 est dans l'obscurité, et le signal d'entrée en 1 est isolé de la capacité mémoire 3 : le dispositif 4 qui suit l'échantillonneur-bloqueur traduit la valeur exacte de la tension mémorisée dans la capacité 3.

L'échantillonneur-bloqueur selon l'invention ne nécessite pas une géométrie particulière pour le transistor 6. En effet, la fréquence d'échantillonnage obtenue, 1 GHz, est déjà en progrès par rapport aux échantillonneurs connus, mais elle est limitée par le temps de charge de la capacité 3, égal à $R_{on} C$, $R_{on}$ étant la résistance passante et C la capacité.

Par conséquent, un transistor 6 qui a une fréquence de coupure supérieure à 1 GHz convient. On sait que la fréquence de coupure d'un transistor est en partie fonction de la distance drain-source. Sur la figure 3, qui représente une vue en plan des métallisations de drain, grille et source du transistor 6, on voit que les distances "d" entre drain et grille et entre grille et source sont suffisantes pour permettre l'éclairement des couches sous-jacentes du canal, tout au moins dans le domaine de fréquences cité, 1 GHz.

Il a été dit que le transistor 6 est polarisé par une tension $V_P$ de façon à être très proche de son point de basculement passant/bloqué. Pour améliorer le système, et annuler l'incertitude à l'ouverture du transistor 6, le laser 9 est lui aussi maintenu proche de son seuil émissif.

On sait -figure 4- que la puissance optique P émise par un laser semiconducteur est quasiment nulle jusqu'à une intensité $i_0$, dite de seuil, du courant I injecté dans le laser. Au delà de cette intensité $i_0$, la puissance optique émise croît très rapidement. Puisque le laser 9 doit émettre en pulsé, pour ouvrir puis fermer alternativement l'interrupteur 6, le courant pulsé qui traverse le laser a une valeur basse égale à ou très proche de $i_0$ : dès qu'arrive une impulsion de courant $i_c$, le laser émet, et comme le transistor 6 est lui-même proche de son seuil, il bascule. Ainsi, il n'y a pas d'incertitude sur le moment d'ouverture ou de fermeture du canal du transistor 6.

En outre, comme il n'y a pas de liaison entre source et grille, le temps de basculement du transistor 6 est indépendant du niveau du signal d'entrée.

Si une fibre optique, ou un élément de fibre optique, est utilisée pour coupler le laser 9 et le transistor 6, les fibres multimodes, de diamètre de coeur de l'ordre de 50 microns sont préférentiellement utilisées à 869 nm avec GaAs, et les fibres monomodes, de diamètre de coeur de l'ordre de 9 microns, sont préférentiellement utilisées à 1500 nm, avec InP.

L'échantillonneur-bloqueur selon l'invention est utilisé en instrumentation, en traitement de données par des circuits intégrés hyperfréquences, ou dans le réseau numérique à intégration de services.

## Revendications

1. Echantillonneur-bloqueur hyperfréquence, comportant un interrupteur placé entre l'entrée (1) d'un signal électrique et une capacité (3) de mémorisation, cet échantillonneur-bloqueur étant caractérisé en ce que l'interrupteur est un transistor (6) à effet de champ muni d'une commande optique (8,9) sur sa région de canal.

2. Echantillonneur-bloqueur selon la revendication 1, caractérisé en ce que le transistor (6) comporte au moins une région de canal réalisée en matériaux du groupe III-V, tels que GaAs, InP, et leurs alliages ternaires et quaternaires.

3. Echantillonneur-bloqueur selon la revendication 1, caractérisé en ce que le transistor (6) est polarisé sur sa grille par une tension continue $V_P$ qui maintient le transistor en un point proche de sa tension de seuil, indépendamment de la valeur du signal d'entrée.

4. Echantillonneur-bloqueur selon la revendication 1, caractérisé en ce que la commande optique de la région de canal du transistor (6), qui s'ajoute à la polarisation continue de la grille, est composée d'un élément de fibre optique (8) et d'un laser semiconducteur (9) pulsé à la fréquence d'échantillonnage de l'échantillonneur-bloqueur.

5. Echantillonneur-bloqueur selon la revendication 4, caractérisé en ce que, dans le cas où le transistor (6) est réalisé en GaAs ou ses alliages, le laser (9) émet un rayonnement pulsé de longueur d'onde $\leqq$ 869 nm.

6. Echantillonneur-bloqueur selon la revendication 4, caractérisé en ce que, dans le cas où le transistor (6) est réalisé en InP ou ses alliages, le laser (9) émet un rayonnement pulsé de longueur d'onde $\leqq$ 1500 nm.

7. Echantillonneur-bloqueur selon la revendication 4, caractérisé en ce que, en vue de diminuer l'incertitude sur le temps de basculement du transistor (6), le laser semiconducteur (9) est polarisé par un courant continu ($i_0$) correspondant à son seuil d'émission optique.

## Patentansprüche

1. Mikrowellentast- und -haltekreis mit einem zwischen dem Eingang (1) für ein elektrisches Signal und einem Speicherkondensator (3) liegenden Schalter, dadurch gekennzeichnet, daß der Schalter ein Feldeffekttransistor (6) ist, der mit einer optischen Steuerung (8, 9) seiner Kanalzone versehen ist.

2. Mikrowellentast- und -haltekreis nach Anspruch 1, dadurch gekennzeichnet, daß der Transistor (6) mindestens eine Kanalzone besitzt, die aus Materialien der Gruppe III-V, wie z.B. GaAs, InP und ihren ternären und quaternären Legierungen besteht.

3. Mikrowellentast- und -haltekreis nach Anspruch 1, dadurch gekennzeichnet, daß der Transistor (6) über sein Gate mit einer Gleichspannung $V_P$ vorgespannt wird, die den Transistor unabhängig vom Wert des Eingangssignals in einem Punkt nahe seiner Schwellspannung hält.

4. Mikrowellentast- und -haltekreis nach Anspruch 1, dadurch gekennzeichnet, daß die optische Steuerung der Kanalzone des Transistors (6), die sich der Gleichvorspannung des Gate überlagert, aus einem Element einer Lichtleitfaser (8) und einem Halbleiterlaser (9) besteht, der mit der Tastfrequenz des Tast- und Haltekreises getaktet ist.

5. Mikrowellentast- und -haltekreis nach Anspruch 4, dadurch gekennzeichnet, daß der Laser (9) eine pulsierende Strahlung einer Wellenlänge $\leqq$ 869 nm aussendet, wenn der Transistor (6) aus GaAs oder Legierungen dieses Materials besteht.

6. Mikrowellentast- und -haltekreis nach Anspruch 4, dadurch gekennzeichnet, daß der Laser (9) eine pulsierende Strahlung einer Wellenlänge $\leqq$ 1500 nm aussendet, wenn der Transistor (6) aus InP oder Legierungen dieses Materials besteht.

7. Mikrowellentast- und -haltekreis nach Anspruch 4, dadurch gekennzeichnet, daß der Halbleiterlaser (9) mit einem Gleichstrom ($i_0$) entsprechend seiner optischen Emissionsschwelle gespeist wird, um die Unsicherheit über den Zeitpunkt des Kippens des Transistors (6) zu verringern.

## Claims

1.  UHF sample-and-hold circuit, including a switch placed between the input (1) of an electrical signal and a memory storage capacitor (3), this sample-and-hold circuit being characterized in that the switch is a field-effect transistor (6) equipped with optical control (8, 9) on its channel region.

2.  Sample-and-hold circuit according to Claim 1, characterized in that the transistor (6) includes at least one channel region produced in materials of the III-V group, such as GaAs, InP, and their ternary and quaternary alloys.

3.  Sample-and-hold circuit according to Claim 1, characterized in that the transistor (6) is biased on its gate by a direct current voltage $V_P$ which keeps the transistor at a point close to its threshold voltage, independently of the value of the input signal.

4.  Sample-and-hold circuit according to Claim 1, characterized in that the optical control of the channel region of the transistor (6) which is added to the direct current bias of the gate, consists of an optical fibre element (8) and of a semiconductor laser (9) pulsed at the sampling frequency of the sample-and-hold circuit.

5.  Sample-and-hold circuit according to Claim 4, characterized in that, in the case in which the transistor (6) is produced in GaAs or its alloys, the laser (9) sends out a pulsed radiation of wavelength $\leqq$ 869 nm.

6.  Sample-and-hold circuit according to Claim 4, characterized in that, in the case in which the transistor (6) is produced in InP or its alloys, the laser (9) sends out a pulsed radiation of wavelength $\leqq$ 1500 nm.

7.  Sample-and-hold circuit according to Claim 4, characterized in that, with a view to diminishing the uncertainty in the change-over time of the transistor (6), the semiconductor laser (9) is biased by a direct current ($I_0$) corresponding to its optical emission threshold.

EP 0 382 610 B1

# FIG_1

# FIG_2

# FIG_3

# FIG_4

6